# EUROPÄISCHE PATENTSCHRIFT

(11) **EP 0 275 430 B1**
(45) Veröffentlichungstag und Bekanntmachung des Hinweises auf die Patenterteilung: **07.07.1993**
(21) Anmeldenummer: 87117788.7
(22) Anmeldetag: 02.12.1987
(51) Int. Cl.: G01S 3/02, G01R 29/10, F41G 7/00, G01S 7/40

(54) **Vorrichtung zur Darstellung von Radarzielen bei der labormässigen Untersuchung von Radarsuchern**
Apparatus for simulating radar targets during the laboratory testing of radar seekers
Dispositif de simulation de cibles radar pendant les essais en laboratoire de chercheurs radar

(30) Priorität: 21.01.1987 DE 3701535
(43) Veröffentlichungstag der Anmeldung: 27.07.1988
(73) Patentinhaber: Bodenseewerk Gerätetechnik GmbH, 88662 Überlingen (DE)
(72) Erfinder: Platt, Karl Ernst, Dipl.-Ing., D-7770 Überlingen (DE); Scherer, Nicolaus Harald Ernst, Dr., D-7770 Überlingen (DE)
(74) Vertreter: Weisse, Jürgen, Dipl.-Phys. Patentanwalt

(56) Entgegenhaltungen:
- DE-A- 2 413 373
- US-A- 3 806 943
- US-A- 4 507 660
- IEEE TRANSACTIONS ON ANTENNAS AND PROPAGATION, Band AP-21, Nr. 4, Juli 1973, Seiten 579-581; R.B. DYBDAL et al.: "VHF to EHF performance of a 90-ft Quasi-tapered anechoic chamber"
- SOVIET INVENTIONS ILLUSTRATED, Woche E02, 24. Oktober 1982, Section EI, class S01, Seite 10, Zusammenfassung Nr. A3553 E/02, Derwent Publications Ltd., London, GB; SU-A- 815 681 (A.A. ZINICHEV) 23-03-1981
- SOVIET INVENTIONS ILLUSTRATED, Woche Y1, 15. Februar 1977, Section R, class R48, Seite 7, Zusammenfassung Nr. A1300Y/01, Derwent Publications Ltd, London, GB; & SU-A-512 522 (V.S. FOMIN) 01-06-1976

## Beschreibung

Die Erfindung betrifft eine Prüfvorrichtung für Radarsucher oder Multimodesucher mit Radarkanal, enthaltend
(a) eine radarechofreie Kammer aus einem Hohlkörper mit Radarstrahlung absorbierenden Wänden,
(b) einen Radarsender an einem geschlossenen, konischen Ende des Hohlkörpers,
(c) einen Radarsucher, der nur die unmittelbar von dem Radarsender ausgehende Radarstrahlung empfängt, wobei
(d) der Radarsender und der Radarsucher relativ zueinander beweglich sind.

Eine bekannte solche Prüfvorrichtung (US-A-3 806 943) enthält als Hohlkörper eine zylindrische Kammer, deren Innenwand mit einem Radarstrahlung absorbierenden Material ausgekleidet ist. Die Auskleidung ist mit einer Vielzahl dicht nebeneinander angeordneter Spitzen versehen. Dadurch wird verhindert, dass von einem Radarsender ausgehende Radarstrahlen an der Innenwand in Richtung auf den Radarsucher reflektiert werden. Vielmehr ist sichergestellt, dass Radarstrahlen an diesen Wänden sehr schnell absorbiert werden. Der Hohlkörper ist an einem Ende durch eine ebene Stirnwand begrenzt. An das andere Ende ist ein sich konisch zum Inneren des Hohlkörpers erweiternder Trichter mit einem Radarsender angebaut. Der Radarsender befindet sich am geschlossenen Ende des Trichters, der um seine Längsachse drehbar ist. Innerhalb des Hohlkörpers befindet sich eine Antenne für Radarstrahlung; die Antenne ist in der Höhe verstellbar und um ihre Längsachse drehbar.

Eine weitere bekannte Prüfvorrichtung (DE-A-2 413 373) enthält ebenfalls einen Hohlkörper mit einer strahlungabsorbierenden Auskleidung. Der Hohlkörper enthält einen zylindrischen, an einem Ende geschlossenen Abschnitt, der den Empfänger aufnimmt und am anderen Ende in einen konischen Abschnitt übergeht. Der Radarsender ist in ein offenes Ende des konischen Abschnitts in einen Trichter eingebaut. Der Trichter ist so konstruiert und angeordnet, dass von seiner Innenwand reflektierte Strahlung zusammen mit der direkten Strahlung in einer "ruhigen Zone" auf den Empfänger trifft.

Insbesondere betrifft die Prüfvorrichtung die Darstellung aktiver Radarziele. Zur Prüfung des Verhaltens von mit einem Sucher versehenen Flugkörpern ist das sogen. "HWIL"-Simulationsverfahren gebräuchlich (HWIL = Hardware-in-the-loop). Dabei wird der Sucher eines realen Flugkörpers mit Strahlung beaufschlagt, wie er sie im tatsächlichen Einsatz empfangen würde. Es wird dann die Reaktion des Flugkörpers oder des Suchers auf diese Strahlung abgegriffen und beispielsweise in einen Rechner eingegeben, der das aerodynamische Verhalten des Flugkörpers simuliert. Es tritt dabei das Problem auf, die vom Sucher im tatsächlichen Einsatz vom Ziel empfangene Strahlung, beispielsweise Radarstrahlung, darzustellen. Im freien Raum fällt die Strahlung vom Ziel nur in direkter Linie auf den Empfänger des Suchers. Es sind keine Wände o. dgl. vorhanden, an denen eine Reflexion der Strahlung erfolgt. Diese Verhältnisse müssen im Labor nachgebildet werden.

Es sind hierzu radarechofreie Kammern der vorgenannten Art bekannt. Dabei handelt es sich um grosse Hallen, in denen der gesamte zu untersuchende Flugkörper oder Sucher angeordnet wird. Durch die reflektionsfreie Auskleidung der Innenwand der Kammern wird die Eigenschaft des freien Raums nachgebildet, kein Radarecho zu liefern.

Zur Darstellung bewegter, Radarstrahlen aussendender Ziele in diesen radarechofreien Kammern werden verschiedene Verfahren angewandt:

Es ist bekannt, die Bewegungen von Sucher und Ziel vom inertialen Bezugssystem in das Sichtlinien-Bezugssystem zu transformieren und die Signale im Sucher elektrisch zu korrigieren. Das Ziel, nämlich der Sender der Radarsignale, ist dabei feststehend angeordnet. Die Bewegung des Ziels wird simuliert, also nicht physikalisch dargestellt. Diese Lösung läßt jedoch einige Probleme echter Sucher unberücksichtigt. Sie ist einer Anordnung mit einem tatsächlich räumlich gegenüber dem Sucher bewegten Ziel nicht gleichwertig.

Es ist weiterhin bekannt, einen Radarsender innerhalb einer radarechofreien Kammer durch mechanische Transporteinrichtungen physikalisch relativ zu dem Sucher zu bewegen. Die auf diese Weise darstellbaren Winkelbereiche der Sichtlinie sind sehr beschränkt. Große Winkelbereiche, in denen die Sichtlinie verändert werden kann, erfordern große Abmessungen der radarechofreien Kammer und aufwendige Transporteinrichtungen für den Radarsender.

Es ist weiterhin eine Vorrichtung bekannt, bei welcher die Bewegung des Ziels durch phasengesteuerte Antennen in der radarechofreien Kammer dargestellt wird. Es wird dort also nicht eine als Radarsender dienende Antenne mechanisch bewegt, sondern es ist eine Reihe von feststehenden Antennen vorgesehen, die bezüglich Amplitude und/oder Phase derart angesteuert werden, daß ein bewegtes scheinbares Strahlungszentrum erhalten wird. Abhängig vom geforderten Sichtlinienschwenkbereich und von der geforderten Winkelgenauigkeit erfordert diese Art der Darstellung bewegter Ziele eine sehr grobe Anzahl von aufwendigen Antennen.

Allen bekannten Lösungen gemeinsam ist, daß sie außerordentlich aufwendig sind.

Der Erfindung liegt die Aufgabe zugrunde, eine Prüfvorrichtung der eingangs genannten Art wie in Anspruch 1 definiert auszubilden, so dass darin für den Radarsucher die Verhältnisse des freien Raumes mit einem darin bewegten, Radarstrahlung aussendenden Ziel mit möglichst geringem Aufwand nachgebildet werden.

Eine weitere Aufgabe der Erfindung besteht darin, bei einer Prüfvorrichtung der eingangs definierten Art grosse Azimut- und Elevationswinkel der Sichtlinie darzustellen.

Erfindungsgemäss wird diese Aufgabe dadurch gelöst, dass
(e) der Radarsender fest an dem Hohlkörper angeordnet ist,
(f) der Hohlkörper eine sucherseitige Öffnung aufweist,
(g) der Hohlkörper als Strahlenfalle ausgebildet ist, in der Radarstrahlung, die auf die Innenwand trifft, nicht durch die Öffnung austritt, sondern in den Hohlkörper hineinreflektiert wird, und
(h) der Hohlkörper in einer kardanischen Aufhängung gelagert ist, deren Achsschnittpunkt im Kardanmittelpunkt des kardanisch gelagerten Radarsuchers liegt.

Es wird also nicht eine aufwendige hallenartige radarechofreie Kammer verwendet, in welcher der Suchkopf angeordnet ist, sondern als radarechofreie Kammer dient ein Hohlkörper, der um den Suchkopf herum beweglich ist. Die Form dieses Hohlkörpers ist so gewählt, dass er als Strahlenfalle wirkt, also die auf die Wandungen des Hohlkörpers fallende Radarstrahlung, auch wenn sie von diesen Wandungen reflektiert wird, nicht in Richtung des Suchkopfes reflektiert werden kann. Damit kann eine Beaufschlagung des Suchkopfes mit "indirekter" Radarstrahlung oder Radarechos auch bei Verwendung einer relativ kleinen und dadurch kardanisch aufhängbaren radarechofreien Kammer sicher ausgeschlossen werden. In diesem Hohlkörper ist der Radarsender fest angeordnet. Es können mit einer solchen kardanisch aufgehängten Konstruktion relativ grosse Winkel der Sichtlinie von beispielsweise +60° in Azimut und Elevation dargestellt werden.

Weitere Ausgestaltungen der Erfindung sind Gegenstand der Unteransprüche.

Ein Ausführungsbeispiel der Erfindung ist nachstehend unter Bezugnahme auf die zugehörige Zeichnung näher erläutert:

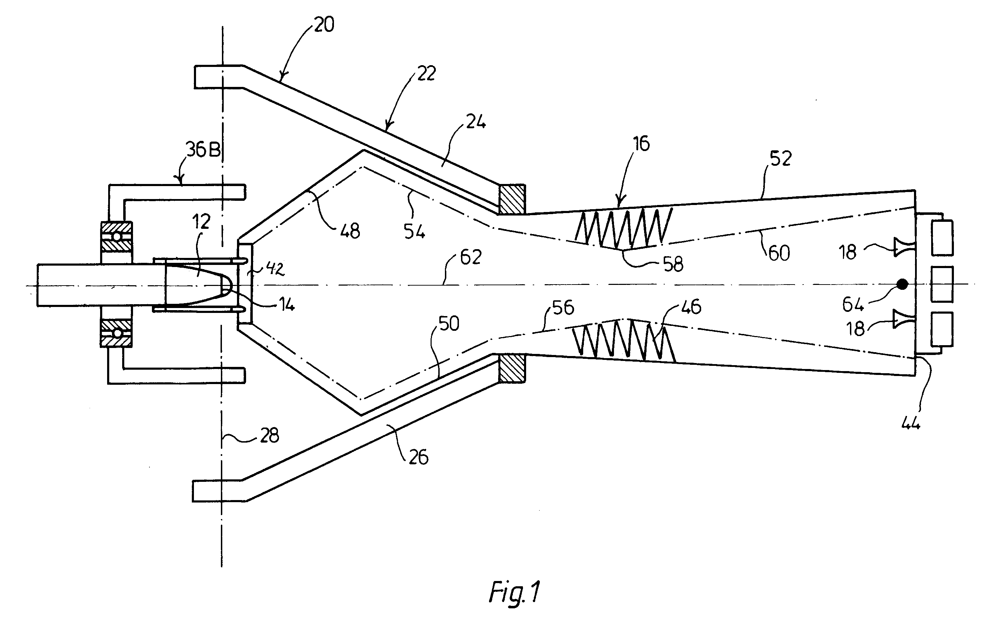

- Fig. 1: zeigt schematisch einen Längsschnitt durch eine Vorrichtung zur Darstellung aktiver Radarziele im Rahmen labormäßiger Untersuchungen des Verhaltens von Radarsuchern.

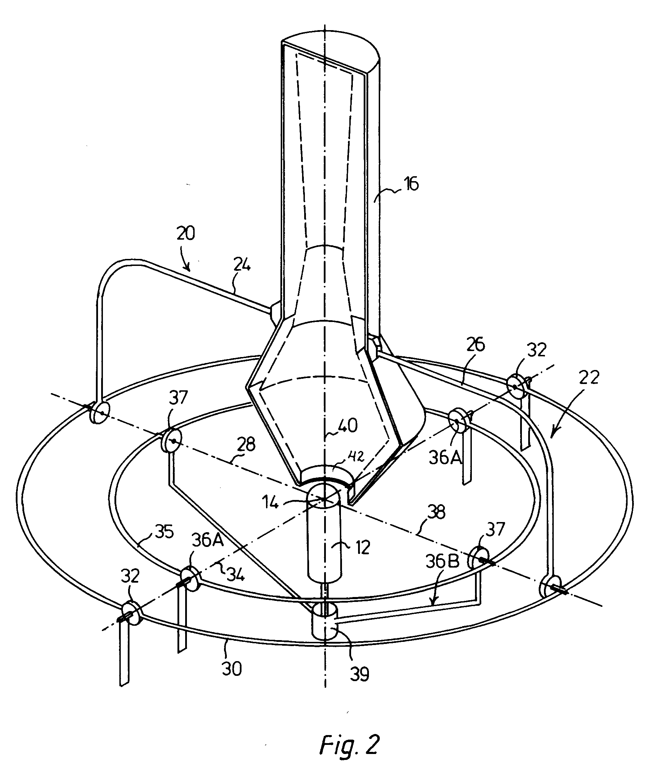

- Fig. 2: zeigt schematisch-perspektivisch die kardanische Lagerung des Suchkopfes und der radarechofreien Kammer.

Mit 12 ist ein Radarsuchkopf eines Flugkörpers bezeichnet. Der Radarsuchkopf 12 enthält einen (nicht dargestellten) mit einem Empfänger versehenen Radarsucher. Der Radarsuchkopf 12 ist in noch zu beschreibender Weise kardanisch um einen Kardanmittelpunkt 14 schwenkbar gelagert und in bekannter Weise auf ein Radarstrahlen aussendendes Ziel ausrichtbar. Um für den Radarsucher eine Umgebung zu schaffen, die bezüglich der am Ort des Empfängers meßbaren Radarstrahlung den Bedingungen des freien Raumes nahekommt, ist eine radarechofreie Kammer vorgesehen. In der radarechofreien Kammer sind Radarstrahlen aussendende Mittel in Form eines Radarsenders vorgesehen. Die radarechofreie Kammer ist von einem um den Radarsucher schwenkbaren Hohlkörper 16 gebildet. Der Hohlkörper 16 hat, wie noch im einzelnen beschrieben wird, eine solche Form, daß er als Strahlenfalle wirkt. In diesem Hohlkörper 16 ist wenigstens ein Radarsender 18 fest angeordnet.

Der Hohlkörper 16 ist unter Verwendung von Leichtbaustoffen hergestellt. Der Hohlkörper 16 ist in einer kardanischen Aufhängung 20 gelagert. Diese kardanische Lagerung enthält einen ersten Kardanrahmen 22, der fest mit dem Hohlkörper 16 verbunden ist und zwei diametral einander gegenüberliegende Arme 24 und 26 aufweist. Mit diesen Armen 24 und 26 sind der erste Kardanrahmen 22 und der Hohlkörper 16 um eine Achse 28 an einem zweiten Kardanrahmen 30 schwenkbar gelagert. Der zweite Kardanrahmen 30 ist in Lagern 32 um die Achse 34 gegenüber einem ortsfesten Gestell drehbar gelagert. Die kardanische Lagerung des Suchkopfes 12 enthält einen äußeren Kardanrahmen 35, der in Lagern 36A um die Achse 34 des ortsfesten Gestells drehbar gelagert ist. An dem äußeren Kardanrahmen 35 ist ein innerer Kardanrahmen 36B über Lager 37 um eine Achse 38 gelagert, die in der dargestellten Mittelstellung mit der Achse 28 zusammenfällt. An dem inneren Kardanrahmen 36 ist der Suchkopf 12 in einem Lager 39 um eine Achse 40 drehbar gelagert.

Die Schnittpunkte der Achsen 28 und 34 und der Achsen 34 und 38 (Kardanmittelpunkt 14) fallen zusammen. Der Achsschnittpunkt der kardanischen Aufhängung 20, also der Schnittpunkt der Achsen 28 und 34 fällt mit dem Kardanmittelpunkt 14 des kardanisch gelagerten Radarsuchkopfes 12 zusammen.

Der Hohlkörper 16 ist ein langgestreckter Rotationskörper, der an einem sucherseitigen Ende eine Öffnung 42 aufweist und auf einer dieser Öffnung 42 gegenüberliegenden, abgeschlossenen Stirnseite 44 den Radarsender 18 trägt. Die Innenfläche des Hohlkörpers 16 ist - ähnlich wie die vorbekannten radarechofreien Kammern mit einer Vielzahl von reflexionshemmenden Vorsprüngen 46 versehen.

Darüber hinaus hat der Hohlkörper 16, wie gesagt, eine solche Form, daß er als "Strahlenfalle" wirkt. Radarstrahlung, die nicht geradlinig durch die Öffnung 42 austritt sondern auf die Innenwandung des Hohlkörpers 16 trifft, wird durch die Form des Hohlkörpers 16 an der Innenwandung so reflektiert, daß sie nicht durch die Öffnung 42 austritt sondern stets wieder in den Hohlkörper 16 hineinreflektiert wird. Zu diesem Zweck ist die Innenfläche des Hohlkörpers 16 von der Öffnung 42 ausgehend zunächst in einem ersten Abschnitt 48 sich konisch erweiternd ausgebildet. Dann verjüngt sich die Innenfläche des Hohlkörpers 16 konisch in einem an den ersten Abschnitt anschließenden zweiten Abschnitt 50. Schließlich weist die Innenfläche einen langgestreckten dritter Abschnitt 52 auf, der sich flach konisch bis zu der abgeschlossenen Stirnfläche 44 erweitert.

Die Einhüllende 54 der reflexionshemmenden Vorsprünge 46 verläuft in dem ersten Abschnitt 48 und in dem zweiten Abschnitt 50 in konstantem Abstand von der Innenfläche des Hohlkörpers 16. In einem ersten Teilabschnitt 56 des dritten Abschnitts 52 verjüngt sich die Einhüllende 54 bis zu einem engsten Querschnitt 58 mit einem gegenüber dem Konuswinkel des zweiten Abschnitts 50 verringerten Konuswinkel. In einem zweiten Teilabschnitt 60 des dritten Abschnitts 52 erweitert sich die Einhüllende 54 wieder konisch von dem engsten Querschnitt 58 zu der abgeschlossenen Stirnfläche hin.

Bei der in der Figur schematisch dargestellten Ausführung sind zwei Radarsender 18 symmetrisch zur Längsachse 62 des Hohlkörpers 16 auf der abgeschlossenen Stirnfläche 44 angeordnet. Auf der Längsachse 62 sitzt ein Infrarotstrahler 64. Auf diese Weise kann ein Multimodesucher geprüft werden, der sowohl auf Radarstrahlen als auch auf Infrarotstrahlen anspricht.

Es gibt Sucher, die sowohl einen Radarkanal im Zentimeter- oder Millimeterradarbereich enthalten als auch Kanäle, die auf andere Zielstrahlungen, z.B. auf Infrarotstrahlung, ansprechen. Bei solchen Suchern (Multimodesuchern) ergibt sich das Problem der gleichzeitigen Darstellungen beider Zielstrahlungen. Es müssen dann die scheinbaren Mittelpunkte der die beiden Strahlungsarten aussendenden Sender exakt zusammenfallen.

Das ist mit einer radarechofreien Kammer der beschriebenen Art besonders günstig zu erreichen, da hier die Sender fest in dem relativ zum Suchkopf 12 schwenkbar angeordneten, als radarechofreie Kammer dienenden Hohlkörper 16 angeordnet ist. Dabei ist ein weiterer Vorteil der beschriebenen radarechofreien Kammer von Bedeutung: Zwischen dem Sucher und dem Sender befinden sich keine Linsensysteme. Solche "Linsen" gibt es im optischen Bereich aber auch im Millimeterwellenbereich. Der Nachteil einer solchen Millimeterwellenlinse bestünde darin, daß diese Linse für andere Strahlung, also beispielsweise für infrarote Strahlung undurchlässig wäre. Die gleichzeitige Darstellung eines Zieles im Radar- und Infrarotbereich wäre daher nicht möglich.

Bei der beschriebenen Vorrichtung sind Radarsender 18 und ein Infrarotstrahler 64 so angeordnet, daß die scheinbaren Mittelpunkte der die beiden Strahlungsarten aussendenden Sender zusammenfallen. Der Suchkopf "sieht" dann ein Ziel, das von der gleichen Stelle aus sowohl Radarstrahlung als auch infrarote Strahlung aussendet. Dieses Ziel bewegt sich gegenüber dem Suchkopf durch Verschwenkung des Hohlkörpers 16, in welchem Radarsender 18 und Infrarotstrahler 64 fest angeordnet sind. Die Strahlung von dem Radarsender 18 wie von dem Infrarotstrahler 64 fällt unmittelbar ohne Zwischenschaltung fokussierender optischer Systeme (Linsen) auf den Suchkopf 12.

## Patentansprüche

1. Prüfvorrichtung für Radarsucher oder Multimodesucher mit Radarkanal, enthaltend
(a) eine radarechofreie Kammer aus einem Hohlkörper (16) mit Radarstrahlung absorbierenden Wänden,
(b) einen Radarsender (18) an einem geschlossenen, konischen Ende des Hohlkörpers (16),
(c) einen Radarsucher, der nur die unmittelbar von dem Radarsender (18) ausgehende Radarstrahlung empfängt, wobei
(d) der Radarsender (18) und der Radarsucher relativ zueinander beweglich sind,
**dadurch gekennzeichnet, dass**
(e) der Radarsender (18) fest an dem Hohlkörper (16) angeordnet ist,
(f) der Hohlkörper (16) eine sucherseitige Öffnung (42) aufweist,
(g) der Hohlkörper (16) als Strahlenfalle ausgebildet ist, in der Radarstrahlung, die auf die Innenwand trifft, nicht durch die Öffnung (42) austritt, sondern in den Hohlkörper (16) hineinreflektiert wird, und
(h) der Hohlkörper (16) in einer kardanischen Aufhängung (20) gelagert ist, deren Achsschnittpunkt im Kardanmittelpunkt (14) des kardanisch gelagerten Radarsuchers liegt.

2. Vorrichtung nach Anspruch 1 , dadurch gekennzeichnet, daß der Hohlkörper (16) unter Verwendung von Leichtbaustoffen hergestellt ist.

3. Vorrichtung nach einem der Ansprüche 1 oder 2, dadurch gekennzeichnet, daß der Hohlkörper (16) ein langgestreckter Rotationskörper ist, der an einem sucherseitigen Ende die Öffnung (42) aufweist und auf einer dieser Öffnung (42) gegenüberliegenden, abgeschlossenen Stirnfläche (44) den Radarsender (18) trägt.

4. Vorrichtung nach Anspruch 3, dadurch gekennzeichnet, daß die Innenfläche des Hohlkörpers (16) mit einer Vielzahl von reflexionshemmenden Vorsprüngen (46) versehen ist.

5. Vorrichtung nach Anspruch 4, dadurch gekennzeichnet, daß
(a) die Innenfläche des Hohlkörpers (16) sich von der Öffnung (42) ausgehend in einem ersten Abschnitt (48) zunächst konisch erweitert,
(b) dann in einem zweiten, daran anschließenden zweiten Abschnitt (50) sich wieder konisch verjüngt und
(c) einen langgestreckten dritten Abschnitt (52) aufweist, der sich flach konisch bis zu der abgeschlossenen Stirnfläche (44) erweitert.

6. Vorrichtung nach Anspruch 5, dadurch gekennzeichnet, daß die Einhüllende (54) der reflexionshemmenden Vorsprünge (46)
(a) in dem ersten und dem zweiten Abschnitt (48,50) in konstantem Abstand von der Innenfläche des Hohlkörpers (16) verläuft,
(b) in einem ersten Teilabschnitt (56) des dritten Abschnitts (52) sich bis zu einem engsten Querschnitt (58) mit einem gegenüber dem Konuswinkel des zweiten Abschnitts (50) verringerten Konuswinkel weiter verjüngt und
(c) in einem zweiten Teilabschnitt (60) des dritten Abschnitts (52) sich von dem engsten Querschnitt (58) zu der abgeschlossenen Stirnfläche (44) hin mit einem kleinen Konuswinkel wieder konisch erweitert.

7. Vorrichtung nach einem der Ansprüche 1 bis 6, dadurch gekennzeichnet, daß
(a) in dem Hohlkörper (16) zusätzlich zu dem Radarsender (18) weitere strahlungsaussendende Mittel (64) angeordnet sind und
(b) die Strahlung von dem Radarsender (18) und von den weiteren strahlungsaussendenden Mitteln (64) unmittelbar, ohne fokussierende optische Glieder auf den Sucher fällt.

8. Vorrichtung nach Anspruch 7, dadurch gekennzeichnet, daß der Radarsender (18) und die weiteren strahlungsaussendenden Mittel (64) so angeordnet sind, daß die scheinbaren Mittelpunkte der die beiden Strahlungsarten aussendenden Mittel zusammenfallen.

## Claims

1. A device for the simulation of radar targets or of multimode seekers having a radar channel, comprising
(a) a radar anechoic chamber made of a hollow body (16) having radar radiation absorbing walls,
(b) a radar transmitter (18) arranged at a closed conical end of the hollow body (16),
(c) a radar seekers for reception only of the radar radiation immediately emitted by the radar transmitter (18),
(d) the radar transmitter (18) and the radar seeker beeing movable relatively against eachother
**characterised in that**
(e) the radar transmitter (18) is fixed by arranged at the hollow body (16),
(f) the hollow body (16) has an aperture (42) at the seekers side,
(g) the hollow body (16) acts as a ray trap such that radar radiation hitting its inner wall does not pass through the aperture (42), however is reflected into the hollow body (16), and
(h) the hollow body (16) is mounted in a gimbal suspension (20), the intersection of the axes of which is located in the gimbal center point (14) of the gimbal suspended radar seeker.

2. Device as set forth in claim 1, characterised in that the hollow body (16) is constructed with use of light weight materials.

3. Device as set forth in claim 1 or 2, characterised in that the hollow body (16) is an elongated body of revolution, which has the opening (42) at one end on the side auf the seeker and carries the radar transmitter (12) on a closed end surface (44) opposite this opening (42).

4. Device as set forth in claim 3, characterised in that the inner surface of the hollow body (16) is provided with a plurality of projections (46) inhibiting reflection.

5. Device as set forth in claim 4, characterised in that
(a) the inner surface of the hollow body (16) is flared starting from the opening (42) in a first section (48),
(b) then again is tapered in a second section (50) communication with the first section, and
(c) has an elongated third section (52), which is flared at a small angle up to the closed end surface (44).

6. Device as set forth in claim 5, characterised in that the envelope (54) of the projections (46) inhibiting reflection
(a) in the first and the second section (48, 50), extends at constant distance from the inner surface of the hollow body (16),
(b) in a first partial section (56) of the third section (52) is further tapered with a reduced cone angle as compared to the cone angle of the second section (50) up to a narrowest cross section (58), and
(c) in a second partial section (60) of the third section (52), is flared with a small cone angle from the narrowest cross section (58) towards the closed end surface (44).

7. Device as set forth in any of the claims 1 to 6, characterised in that
(a) further means (64) emitting radiation are arranged in the hollow body (16) in addition to radar transmitter (18), and
(b) the radiation from the radar transmitter (18) and from the further means (64) emitting radiation directly impinges upon the seeker without focussing optical elements.

8. Device as set forth in claim 7, characterised in that the radar transmitter (18) and the further means (64) emitting radiation are arranged, such that the apparent center points of the means emitting the two radiation types coincide.

## Revendications

1. Dispositif de vérification pour des chercheurs radar ou des chercheurs multimodes avec un canal de radar, comprenant
(a) une chambre sans écho de radar d'un corps creux (16) ayant des parois absorbant le rayonnement radar,
(b) un émetteur radar (18) sur une extrémité fermée conique du corps creux (16),
(c) un chercheur radar ne recevant que le rayonnement radar directement émis par l'émetteur radar (18),
(d) l'émetteur radar (18) et le chercheur radar sont mobiles l'un par rapport à l'autre, caractérisé par le fait que
(e) l'émetteur radar (18) est disposé fixement sur le corps creux (16),
(f) le corps creux (16) présente une ouverture (42) du côté du chercheur,
(g) le corps creux (16) est formé comme piège de rayons dans lequel le rayonnement radar tombant sur la paroi intérieure ne sort pas par l'ouverture (42) mais est réflété dans le corps creux (16), et
(h) le corps creux (16) est monté dans une suspension cardan (20) dont le point d'intersection des axes est disposé dans le centre cardan (14) du chercheur radar monté sur le cardan.

2. Dispositif selon la revendication 1, caractérisé par le fait que le corps creux (16) est fabriqué en matières légères.

3. Dispositif selon l'une des revendications 1 ou 2, caractérisé par le fait que le corps creux (16) est un corps de rotation allongé qui présente l'ouverture (42) sur une extrémité sur le côté du chercheur, et qui porte l'émetteur radar (18) sur un front fermé (44) opposé à cette ouverture (42).

4. Dispositif selon la revendication 3, caractérisé par le fait que la surface intérieure du corps creux (16) est munie d'une pluralité de saillies (46) inhibitrices de réflexions.

5. Dispositif selon la revendication 4, caractérisé par le fait que
(a) la surface intérieure du corps creux (16) s'élargit d'abord coniquement en partant de l'ouverture (42) dans une première section (48),
(b) ensuite, dans une seconde section adjacente (50), elle se rétrécit de nouveau coniquement, et
(b) elle présente une troisième section allongées (52) qui s'élargit en forme de cône plane jusqu'au front fermé (44).

6. Dispositif selon la revendication 5, caractérisé par le fait que l'enveloppe (54) des saillies inhibitrices de réflexions (46)
(a) s'étend dans la première et la seconde section (48,50) à écart égal de la surface intérieure du corps creux (16),
(b) se rétrécit dans une première section partielle (56) de la troisième section (52) jusqu'à la coupe transversale la plus étroite (58) ayant un angle de cône réduit par rapport à l'angle de cône de la seconde section (50), et
(c) s'élargit de nouveau coniquement dans une seconde section partielle (60) de la troisième section (52) depuis la coupe transversale la plus étroite (58) vers le front fermé (44) avec un petit angle de cône.

7. Dispositif selon l'une des revendications 1 à 6, caractérisé par le fait que
(a) d'autres moyens émettant des rayons (64) sont disposés en plus dans le corps creux (16), et
(b) le rayonnement de l'émetteur radar (18) et d'autres moyens émettant des rayons (64) tombe directement sur le chercheur sans éléments optiques de focus.

8. Dispositif selon la revendication 7, caractérisé par le fait que l'émetteur radar (18) et les autres moyens émettant des rayons (64) sont disposés de sorte que les centres apparents des moyens émettant les deux sortes de rayonnement coincident.
